Europäisches Patentamt

European Patent Office

Office européen des brevets

(11) Numéro de publication: **0 312 180 B1**

(12) # FASCICULE DE BREVET EUROPEEN

(45) Date de publication de fascicule du brevet: **12.10.94**  (51) Int. Cl.⁵: **G01S 13/34**, G01R 23/167

(21) Numéro de dépôt: **88202303.9**

(22) Date de dépôt: **14.10.88**

(54) **Dispositif pour mesurer la distance "h" qui le sépare d'un objet.**

(30) Priorité: **16.10.87 FR 8714289**

(43) Date de publication de la demande:
**19.04.89 Bulletin 89/16**

(45) Mention de la délivrance du brevet:
**12.10.94 Bulletin 94/41**

(84) Etats contractants désignés:
**DE FR GB**

(56) Documents cités:
**EP-A- 0 098 748**
**EP-A- 0 146 175**
**WO-A-82/04488**
**GB-A- 2 083 312**

**IEEE TRANSACTIONS ON AEROSPACE AND ELECTRONIC SYSTEMS, vol. AES-22, no. 4, juillet 1986, pages 422-430, IEEE, New York, US; D.HUSH et al.:"Instantaneous frequency estimation using adaptive linear predictor weights"**

**IEEE TRANSACTIONS ON AEROSPACE AND ELECTRONIC SYSTEMS, vol. AES-16, no. 4, juillet 1980, pages 517-525, IEEE, New York, US; J.P. TOOMEY; "High-resolution frequency measurement by linear prediction"**

(73) Titulaire: **THOMSON-TRT DEFENSE**
**88, rue Brillat Savarin**
**F-75013 Paris (FR)**

(72) Inventeur: **Hethuin, Serge**
**Societe Civile S.P.I.D.**
**209 rue de l'Université**
**F-75007 Paris (FR)**

(74) Mandataire: **Courtellemont, Alain et al**
**THOMSON-CSF,**
**SCPI,**
**B.P. 329,**
**50, rue Jean-Pierre Timbaud**
**F-92402 Courbevoie Cédex (FR)**

Rank Xerox (UK) Business Services
(3.10/3.09/3.3.3)

**Description**

La présente invention concerne un dipositif pour mesurer la distance "h" qui le sépare d'un objet, dispositif comportant un circuit d'émission pour émettre une onde présentant des périodes de modulation linéaire de fréquence en direction de l'objet, un circuit de réception pour recevoir l'onde réfléchie par l'objet, un circuit mélangeur pour former une onde de battement entre l'onde émise et l'onde reçue et un organe de traitement opérant sur des échantillons de l'onde de battement pour fournir à un indicateur l'information de distance "h".

De tels dispositifs trouvent d'importantes applications dans le domaine de la radionavigation pour mesurer l'altitude, l'objet étant dans ce cas le sol. D'autres applications peuvent être aussi citées telles que la mesure de la hauteur de métal dans un haut-fourneau.

Un dispositif de ce genre est décrit dans le brevet des Etats-Unis d'Amérique 4 568 938 ou dans le brevet GB 2 083 312.

Ce dispositif effectuant directement une transformation de Fourier sur des échantillons de l'onde de battement n'est pas très adapté à la mesure de faible distance. En effet, pour éviter qu'à chaque période de la modulation de fréquence, les ruptures de phase du signal de battement ne distordent le spectre évalué par transformée de Fourier, on ne doit considérer que les échantillons du signal de battement obtenus sur une seule période de modulation. Pour apprécier les faibles distances, on est contraint de prendre une pente élevée de la modulation de fréquence. Une variation de pente élevée ne peut pas durer très longtemps et n'aboutit qu'à un petit nombre d'échantillons à traiter. Dans ce cas, la transformée de Fourier se révèle peu efficace.

La présente invention propose un dispositif du genre mentioné dans le préambule, paraticulièrement adapté au cas des valeurs "h" peu élevées.

Pour cela, un tel dispositif est remarquable en ce que l'organe de traitement comporte des moyens de prédiction d'ordre p à coefficients "$a_i$" ajustables pour prédire la valeur d'un échantillon présent à partir de "p" échantillons antérieurs obtenus sur une même période de modulation qui comprennent des moyens de stockage des "p" premiers échantillons obtenus sur une période de modulation en maintenant la cohérence de phase des échantillons de période à période, des moyens de détermination d'erreur pour élaborer une information d'erreur entre l'échantillon prédit et l'échantillon présent et des moyens d'ajustages pour corriger, par une méthode itérative, des coefficients initiaux afin de minimiser l'information d'erreur, ces coefficients initiaux étant choisis dans un premier ensemble de coefficients initiaux fixes ou dans un deuxième ensemble constitué par la valeur des coefficients établis lors d'une période de modulation précédente, des moyens de calculs de densité spectrale pour établir les raies du spectre des échantillons de l'onde de battement à partir des coefficients "$a_i$" et des moyens de détermination de l'information de distance à fournir à l'indicateur, élaborée à partir desdites raies.

Il est à noter que la détermination d'un spectre à partir des coefficients d'un prédicteur est décrite dans le document IEEE Transactions on Aerospace and Electronic Systems, vol.AES-22, n°4, juillet 1986, pages 422-430, de D. Hush et al : "Instantaneous Frequency Estimation Using Adaptive Linear Predictor Weights". Ce document ne mentionne pas l'application envisagée où l'on est confronté avec la mise à jour des coefficients entre deux périodes de modulation de fréquence au moyen de peu d'échantillons.

La description suivante faite en regard des dessins annexés, le tout donné à titre d'exemple non limitatif, fera bien comprendre comment l'invention peut être réalisée.

La figure 1 montre un dispositif conforme à l'invention.

La figure 2 montre l'allure de la variation de fréquence de l'onde émise et la formation de l'onde de battement.

Les figures 3, 4 et 5 montrent l'organigramme du programme de traitement mis en oeuvre par l'invention.

La figure 6 montre l'organigramme du programme d'interruption mis en oeuvre par l'invention.

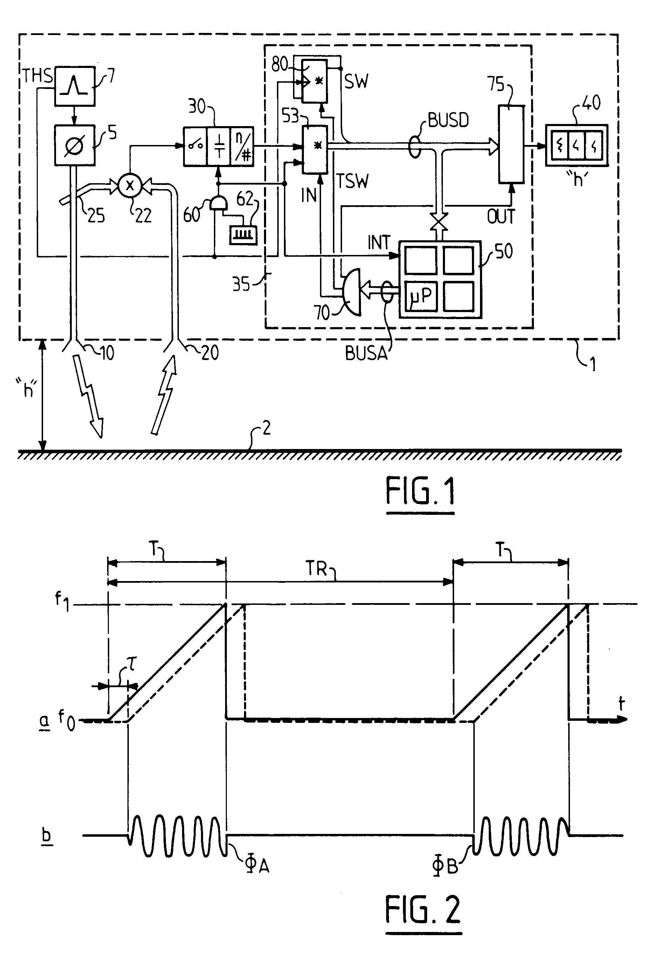

A la figure 1, la référence 1 indique le dispositif, objet de l'invention. Le dispositif est placé à une altitude "h" du sol 2. Le dispositif comporte un circuit d'émission formé à partir d'un oscillateur hyperfréquence 5 qui est muni d'une commande de fréquence recevant les signaux en dents de scie fournis par un générateur 7. L'onde élaborée par l'oscillateur 5 est émise vers le sol 2 par l'intermédiaire d'une antenne d'émission 10.

Le circuit de réception comporte tout d'abord une antenne de réception 20 pour recevoir l'onde réfléchie par le sol 2 et un circuit mélangeur 22 à deux entrées ; une de ses entrées est reliée à l'embouchure de l'antenne de réception 20 et l'autre à la sortie de l'oscillateur 5 par l'intermédiaire d'un coupleur 25 qui prélève pour le circuit mélangeur 22 une petite partie de l'onde émise. L'onde de battement à la sortie du circuit mélangeur est convertie en échantillons numériques par un ensemble d'échantillonneur-bloqueur et convertisseur analogique-numérique ; cet ensemble porte la référence 30. Un organe de traitement 35 opère sur les échantillons fournis par l'ensemble 30 et délivre une information exploitable pour un indicateur 40 ; ainsi, la valeur de "h" est rendue discernable à l'utilisateur.

Conformément à l'invention, le dispositif pour mesurer la distance "h" est pourvu d'un organe de traitement 35 qui comporte :

- des moyens de prédiction à "p" coefficients "$a_i$" ajustables pour fournir un échantillon prédit $y(n)$ qui est une prédiction de l'échantillon $x(n)$ de l'onde de battement à l'instant $n.TS$ ($n$ : entier et $TS$ : période d'échantillonnage), cet échantillon $y(n)$ étant élaboré au moyen de "p" échantillons antérieurs de l'onde de battement obtenue à partir d'une même dent de scie, soient $x(n-1)$, $x(n-2)$,... $x(n-p)$ de sorte que l'échantillon prédit s'écrit :

$$y(n) = - \sum_{i=1}^{p} a_i \, x(n-i) \qquad (1)$$

- des moyens de détermination d'erreur pour élaborer une information sur l'erreur $e(n)$ survenant entre l'échantillon prédit et l'échantillon présent, c'est-à-dire :

$$e(n) = x(n)-y(n) \qquad (2)$$

- des moyens d'ajustage pour agir sur les coefficients "$a_i$" afin de minimiser l'erreur ; pour cela, on utilise par exemple l'algorithme du gradient, les coefficients sont ajustés d'une manière itérative selon la formule suivante :

$$a_i^{n+1} = a_i^n - \mu e(n) \, x(n-i) \qquad \text{où } i = 1 \text{ à } p \qquad (3)$$

où $\mu$ est une constante représentant le pas du gradient, fixant ainsi la vitesse de convergence et la variance de l'erreur résiduelle ; sa valeur est généralement comprise entre $0<\mu<1$, et $n$ définit l'instant d'utilisation,

- des moyens de calcul de densité spectrale de puissance $S(f)$ pour établir les raies de spectre $(f)$ des échantillons de l'onde de battement donnée à partir des coefficients $a_i$ selon la formule :

$$S(f) = \frac{1}{\left| 1+\sum_{i=1}^{P} a_i \, e^{-j2\pi if} \right|^2} \qquad (4)$$

où $j = \sqrt{-1}$, $f = m \, f_e/N = m/N.TS$.

$m$ est un entier représentant le numéro de la raie d'une des $N$ raies du spectre espacées de $1/N.TS$.

- et des moyens de détermination de l'information de distance à fournir à l'indicateur élaborée à partir des raies de densités spectrales (par exemple, on peut prendre la raie de plus forte amplitude).

Les moyens précités de l'organe de traitement 35 sont constitués à partir d'un ensemble à microprocesseur 50; les informations fournies par l'ensemble 30 transistent par un registre 53 dont la sortie du type à trois états est connectée à la ligne commune de données BUSD de l'ensemble 50.

Les données élaborées par l'ensemble 30 sont emmagasinées au fur et à mesure dans le registre 53 au rythme de signaux d'horloge apparaissant à la sortie d'une porte ET 60. A une des deux entrées de cette porte 60 sont appliqués les signaux d'une horloge 62 fixant la fréquence d'échantillonnage $f_e$ égale à $1/TS$. A l'autre entrée on applique un signal THS dérivé du générateur 7 pour rendre passante la porte 60 durant le temps $T$ pendant lequel la dent de scie est engendrée (voir figure 2). Les signaux de la porte 60 sont aussi appliqués à l'entrée INT de l'ensemble 50 pour pouvoir provoquer le déroulement d'un programme d'interruption qui permet d'emmagasiner dans la mémoire interne de l'ensemble 50 des échantillons transitant par le registre 53. Pour cela, l'ensemble 50 engendre, via un décodeur 70 connecté à la ligne commune de code d'adresse BUSA de l'ensemble 50, un signal IN pour mettre à l'état passant la sortie du registre 53. Ce décodeur 70 fournit un signal OUT pour un registre 75 dont l'entrée est connectée à la ligne BUSD et la sortie, à l'indicateur 40. L'ensemble 50 engendre, toujours via le décodeur 70 un signal TSW pour rendre passante la sortie d'une bascule 80 (à trois états). Cette bascule reçoit sur son entrée pour basculement le signal THS provenant du générateur 7. Ainsi, le signal de sortie SW de cette bascule change d'état à chaque début de dent de scie.

Avant d'expliquer plus en détail le fonctionnement du dispositif de l'invention, on doit faire les considérations suivantes :

On admet que les coefficients $a_i$ sont ajustés de sorte que l'erreur e(n) se comporte comme un bruit blanc d'énergie minimale. Soit E(Z), la transformée en Z de cette erreur e(n), c'est-à-dire que l'on a la relation :

$$E(Z) * E(Z^{-1}) = K^2 \qquad (5)$$

où * représente une convolution.

Si on prend maintenant la transformée en Z de l'équation (2) on a :

$$E(Z) = X(Z)-H(Z).X(Z) \qquad (6)$$

où H(Z) est la fonction de transfert du prédicteur :

$$H(Z) = - a_1 Z^{-1} -...- a_p Z^{-p} \qquad (6bis)$$

et X(Z) la transformée en Z des échantillons x(n).
Soit A(Z) la fonction telle que :

$$A(Z) = \frac{E(Z)}{X(Z)} \qquad (7)$$

qui, compte tenu de (6) et (6bis) s'écrit :

$$A(Z) = \sum_{i=0}^{p} a_i \ Z^{-i} \quad \text{avec } a_0 = 1 \qquad (8)$$

en réécrivant (7) on a :

$$X(Z) = \frac{E(Z)}{A(Z)} \qquad (9)$$

d'où la densité spectrale S(f) qui se met, compte tenu de (5), sous la forme :

$$S(f) = |X(f)|^2 = \frac{K^2}{|A(f)|^2} \qquad (10)$$

en remplaçant Z par $e^{j2\pi f}$.

On donne en annexe un procédé qui permet de calculer facilement S(f) en fonction des coefficients $a_i$.

Il est possible maintenant d'expliquer plus en détail le fonctionnement du dispositif de l'invention.

A la figure 2, en $\underline{a}$ on a représenté les variations de fréquences du signal de sortie de l'oscillateur 5 et en $\underline{b}$ l'amplitude de l'onde de battement à la sortie du circuit 22, ces signaux montrés en $\underline{a}$ et $\underline{b}$ évoluant en fonction du temps "t". Pendant une durée de temps T (de 64 μS par exemple), la fréquence de l'onde de l'oscillateur 5 passe de $f_0$ = 4,800 GHz à $f_1$ = 4,825 GHz. Cette même variation se reproduit après un temps TR (de l'ordre de 150 μS par exemple). Ces variations sont représentées en traits pleins. En pointillé, on a représenté, de façon exagérée, les variations de fréquence du signal reçu décalées d'un temps $\tau$. On rappelle que ce temps $\tau$ est lié à la distance "h" par la formule :

4

EP 0 312 180 B1

$$\tau = \frac{2h}{c} \qquad (11)$$

où c est la vitesse de la lumière et comme la fréquence fb du signal de battement à la sortie du circuit mélangeur 22 est liée à ce retard $\tau$ selon la formule :

$$\frac{fb}{\tau} = \frac{f_1 - f_0}{T} \qquad (12)$$

on obtient la distance "h" par

$$h = \frac{1}{2} \cdot fb \cdot \frac{T}{(f_1 - f_0)} \times c \qquad (13)$$

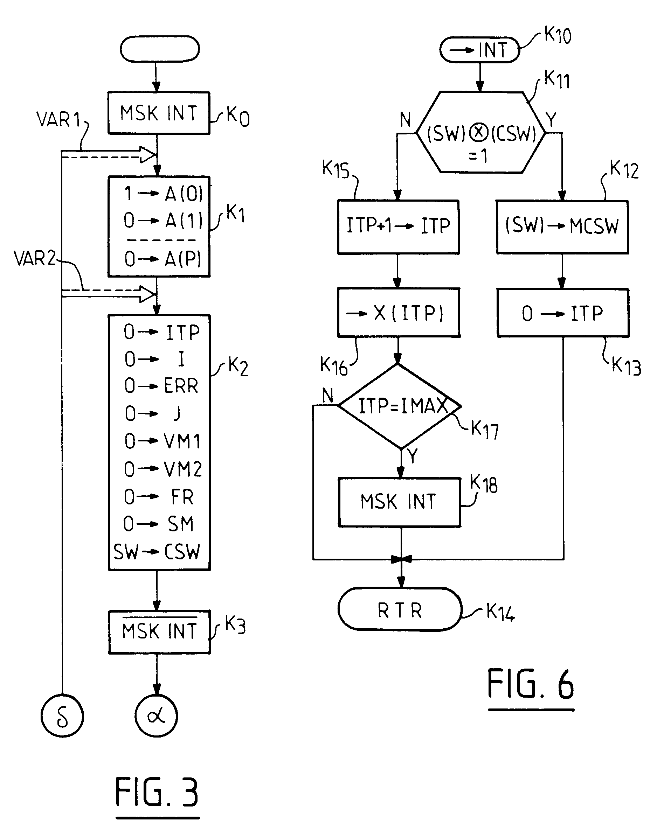

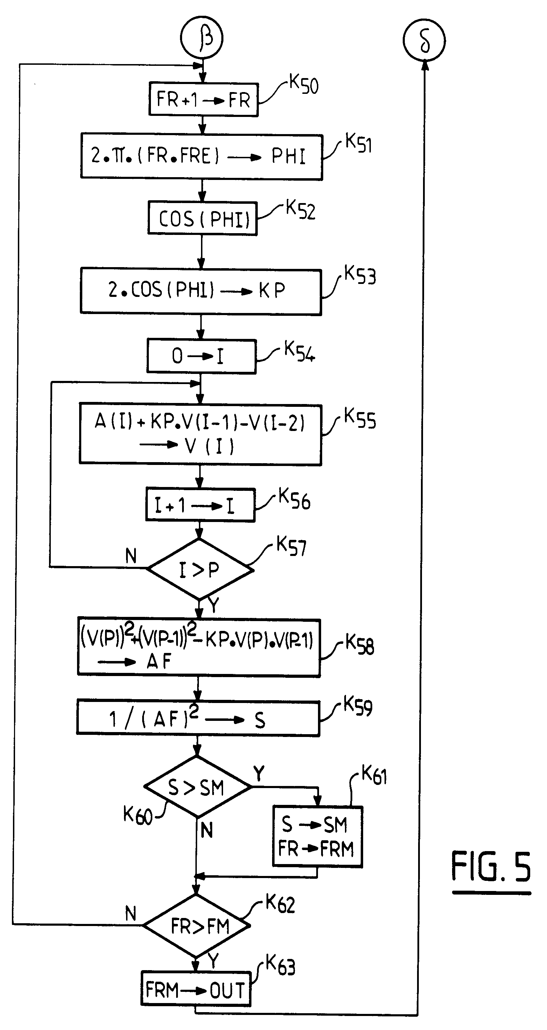

Comme tous les paramètres de la formule (13) sont des constantes, l'organe de traitement 35 doit déterminer la valeur "fb" qui fixe alors la distance "h". On notera bien que du fait des discontinuités des dents de scie, on ne peut assurer une cohérence des phases de l'onde de battement. Ainsi sur la figure 2b la phase $\phi B$ de l'onde de battement provoquée par la deuxième dent de scie est pratiquement en discontinuité avec la phase $\phi A$ de l'onde de battement à la fin de la première dent de scie. Pour éviter cet effet néfaste, l'organe 35 déroule un programme répondant aux considérations ci-dessus. Ce programme est divisé en deux parties : une partie de programme de traitement dont l'organigramme est représenté aux figures 3, 4 et 5 et une partie de programme d'interruption montré à la figure 6.

L'organigramme de la figure 3 est relatif à la phase d'initialisation du programme de traitement. La case K0 de cet organigramme indique un masquage d'interruption, c'est-à-dire que les signaux appliqués à l'entrée INT de l'ensemble 50 ne perturbent pas cette phase d'initialisation ; à la case K1, on donne les valeurs initiales du prédicteur ; on identifiera facilement les contenus des mémoires A(i) avec les $a_i$ de la formule (8) et l'on notera que les coefficients initiaux ont tous la valeur "0" sauf le coefficient $a_0$ contenu dans A(0) qui a la valeur "1". La case K2 indique l'initialisation de différentes variables qui vont intervenir dans la suite du programme et qu'il n'est pas nécessaire de détailler ici. Cette phase d'initialisation se termine par la case K3 qui indique la levée du masquage d'interruption, c'est-à-dire que les signaux appliqués à l'entrée INT vont déclencher le programme d'interruption dont l'organigramme est montré à la figure 6.

Avant de continuer l'explication de la phase du programme de traitement, on détaille le fonctionnement du programme d'interruption.

La case K10 rappelle que cette partie de programme commence par l'apparition d'un signal actif sur l'entrée INT. La case K11 indique un test sur le contenu de la bascule 80. On compare ce contenu, en rendant actif le signal TSW, avec une valeur antérieure de celui-ci enregistrée auparavant, par exemple au cours de la phase d'initialisation. Pour ce test on effectue l'opération OU-Exclusif entre les valeurs SW et le contenu de la mémoire CSW. La valeur 1 indique qu'il y a changement. S'il y a changement on passe à la case K12. A cette case on emmagasine la nouvelle valeur de SW et on met à zéro le compteur d'interruption ITP, case K13 ; la case K14 qui vient ensuite, indique la fin du programme d'interruption. Lorsque le test de la case K11 est négatif, c'est-à-dire lorsque les interruptions surviennent bien dans la même dent de scie, ces dernières sont alors comptées au moyen d'un compteur ITP (case K15) de sorte que les échantillons du registre 53 vont être rangés dans un tableau X(ITP) dont les adresses sont fonction de ce compteur ITP (case K16). Le test montré à la case K17 arrête ce processus de rangement dès que le compteur atteint la valeur IMAX par exemple de l'ordre de 64 ; pour cela, on masque l'interruption (case K18) et l'on retourne au programme de traitement (case K14). Si le compte IMAX n'est pas atteint, on va directement à la case K14.

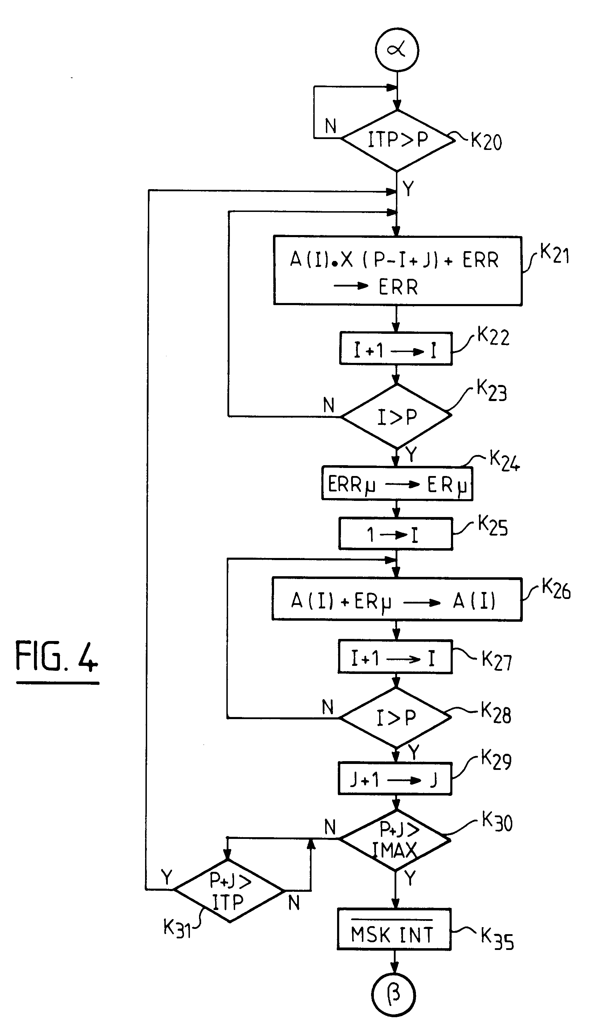

La phase du programme de traitement montrée à la figure 4 est relative à la détermination des coefficients A(I). Avant de commencer cette phase on teste si il y a suffisamment d'échantillons dans le tableau X(I), c'est-à-dire qu'on teste le contenu du compteur ITP par rapport à l'ordre P du prédicteur ; tant que le compte n'est pas atteint, le test se reboucle. Dès que le compte est atteint, démarre alors le processus de calcul d'erreur (voir formule (2) compte tenu de (1)). Cette erreur s'accumule dans une mémoire ERR qui pourra de façon avantageuse être l'accumulateur du processeur utilisé. On remarquera l'argument de X : P-I+J où I s'incrémentant permet de rappeler des échantillons de plus en plus tardifs et J permettra la mise à jour de la formule avec des échantillons de plus en plus récents. Les cases K22 et K23 déterminent l'arrêt de ce calcul d'erreur pour P échantillons successifs.

5

A la case K24 on calcule la constante de correction, fonction de l'erreur (pour calculer le terme correctif à apporter aux coefficients A(I)). On initialise (case K25) un indice I qui va être utilisé pour adresser chacun de ces coefficients A(I) ; la correction est indiquée à la case K26. Les cases K27 et K28 permettent de contrôler le processus de correction pour tous les coefficients A(I). Puis à la case K29 on incrémente d'une unité l'indice J. On vérifie d'abord, case K30, que le tableau des IMAX valeurs de X(I) a bien été traité en conformité avec le test indiqué à la case K17 (figure 6) ; si c'est le cas, on teste si l'argument P + J du tableau X(I) correspond à une valeur emmagasinée (case K31) ; si c'est non, le test de la case K31 est bouclé sur lui-même et il deviendra positif par l'intervention du programme d'interruption. On passera alors à la case K21 pour un nouveau calcul de l'erreur "$e_n$". Si le test de la case K30 est positif, on passe à la case K35 qui indique le masquage des interruptions. Celles-ci n'interviennent plus dans la suite du programme de traitement.

L'opération indiquée à la case K50 montre la présence d'une variable FR qui est relative à la fréquence d'analyse. A la case K51 on détermine une valeur PHI qui est à identifier à la valeur "$2\pi f$" de la formule A11 notamment (voir Annexe), la valeur FRE représentée est à identifier avec $f_e/N$ comme FR est à identifier avec m, puis on en calcule le cosinus (case K52) ce qui est fait par tabulation de préférence, c'est-à-dire que différentes valeurs de cos PHI ont été déterminées au préalable et que la valeur PHI calculée donne l'adresse de la valeur du cosinus tabulé. Puis, cette valeur est multipliée par deux (case K53) pour constituer une constante KP qui va intervenir dans la suite du calcul. A la case K54 on met à zéro un indice I avant d'effectuer le calcul indiqué à la case K55 qui est la mise en application de la formule A13. Les opérations indiquées aux cases K56 et K57 permettent de calculer la formule A13 pour tous les coefficients A(I). La case K58 explicite le calcul de la formule A14. La valeur S de la case K59 est à rapprocher de la valeur X(f) de la formule A15. Cette valeur S représente l'amplitude d'une raie de spectre dont le rang est donné par la valeur de FR. On va utiliser une mémoire indiquée par SM pour contenir la valeur maximale des amplitudes des raies de fréquences dont les rangs sont compris entre (FR, ...FM) et une mémoire FRM pour contenir la valeur du rang que donne cette valeur maximale (voir cases K60 et K61). Le test montré à la case K62, lorsque FR>FM, stoppe le processus de bouclage vers la case K50 et la valeur FM est appliquée à l'indicateur 40 via le registre 75. Pour cela le signal OUT est activé (case K63) puis, selon une première variante de l'invention, on revient à la case K1 flèche VAR1) pour recommencer un autre traitement sur d'autres échantillons en prenant toujours les valeurs 1 ou 0 pour les coefficients de prédiction. Selon une autre variante, on revient à la case K2 (flèche VAR2) c'est-à-dire que les coefficients de prédiction sont initialisés par les valeurs précédemment déterminées.

$$\underline{A\ N\ N\ E\ X\ E}$$

Calcul de :

$$|X(f)|^2 = \frac{1}{\left|1+\sum\limits_{i=1}^{p} a_i\, z^{-i}\right|} \tag{A1}$$

où $Z = e^{j2\pi f}$ avec $f = m\, f_e/N$.

Première étape : calcul de $A(Z)$

$$A(Z) = \sum\limits_{i=0}^{p} a_i\, z^{-i} \qquad \text{avec } a_0 = 1.$$

$$A(Z) = Z^{-p}\{((\ldots(a_0 Z + a_1)Z + a_2)Z +\ldots \tag{A2}$$
$$\ldots + a_{p-1})Z + a_p\}$$

Puis on pose $r_i = r_{i-1}\, Z + a_i$ \hfill (A3)

avec $\qquad r_0 = a_0$

(A3) peut s'écrire :

$$r_i = r_{i-1}\, e^{j2\pi f} + a_i \tag{A4}$$

ou

$$r_{i-1} = r_{i-2}\, e^{j2\pi f} + a_{i-1} \tag{A5}$$

ou encore

$$r_{i-1}\, e^{-j2\pi f} = r_{i-2} + a_{i-1}\, e^{-j2\pi f} \tag{A6}$$

En effectuant la différence des relations (A4) et (A6) on obtient :

$$r_i - r_{i-1}e^{-j2\pi f} = a_i - a_{i-1}e^{-j2\pi f} + r_{i-1}e^{j2\pi f} - r_{i-2} \tag{A7}$$

d'où :

$$r_i = a_i - a_{i-1}\cdot e^{-j2\pi f} + 2\cos(2\pi f)r_{i-1} - r_{i-2} \tag{A8}$$

Si on pose :

$$r_i = v_i - e^{-j2\pi f}\, v_{i-1} \tag{A9}$$

alors :

$$v_i - e^{-j2\pi f}\cdot v_{i-1} = a_i - a_{i-1}\cdot e^{-j2\pi f} + 2\cos(2\pi f) - (v_{i-1} - e^{-j2\pi f}\cdot v_{i-2})$$
$$- (v_{i-2} - e^{-j2\pi f}\cdot v_{i-3})$$

$$v_i - e^{-j2\pi f}.v_{i-1} = a_i + 2\cos(2\pi f).v_{i-1} - v_{i-2})$$

$$- e^{-j2\pi f}.(a_{i-1} + 2\cos(2\pi f)v_{i-2} - v_{i-3}) \tag{A10}$$

Par identification on trouve :

$$v_i = a_i + 2\cos(2\pi f)v_{i-1} - v_{i-2} \tag{A11}$$

or

$$r_p = v_p - e^{-j2\pi f}v_{p-1}$$

et

$$\left|A(Z)\right| = \left|r_p\right|$$

on aboutit à :

$$\left|A(Z)\right|^2 = (v_p - \cos(2\pi f)v_{p-1})^2 + (\sin 2\pi f.v_{p-1})^2$$

$$\left|A(Z)\right|^2 = v_p^2 + v_{p-1}^2 - 2\cos(2\pi f).v_p.v_{p-1} \tag{A12}$$

L'algorithme peut se résumer en deux phases, pour chaque raie f de rang m recherchée :

- première phase : on prend comme conditions initiales :

$$v_{-1} = 0$$

$$v_{-2} = 0$$

- deuxième phase : pour les p coefficients, c'est-à-dire pour i = 0,...p, on effectue :

$$v_i = a_i + 2\cos(2\pi m).v_{i-1} - v_{i-2} \tag{A13}$$

$$\left|A(f)\right|^2 = v_p^2 + v_{p-1}^2 - 2\cos(2\pi f).v_p - v_{p-1} \tag{A14}$$

<u>Deuxième étape</u> :

Pour chaque raie f de rang m, on effectue l'opération ci-dessous :

$$\left|X(f)\right|^2 = \frac{1}{\left|A(f)\right|^2}$$

**Revendications**

1. Dispositif pour mesurer la distance "h" qui le sépare d'un objet, dispositif comportant un circuit d'émission (5-10) pour émettre une onde présentant des périodes de modulation linéaire de fréquence en direction de l'objet, un circuit de réception (20) pour recevoir l'onde réfléchie par l'objet, un circuit mélangeur (22) pour former une onde de battement entre l'onde émise et l'onde reçue et un organe de traitement (35) opérant sur des échantillons de l'onde de battement pour fournir à un indicateur (40) l'information de distance "h", caractérisé en ce que l'organe de traitement comporte des moyens de prédiction d'ordre p à coefficients "a$_i$" ajustables pour prédire la valeur d'un échantillon présent à partir de "p" échantillons antérieurs obtenus sur une même période de modulation qui comprennent des moyens de stockage des "p" premiers échantillons obtenus sur une période de modulation en maintenant la cohérence de phase des échantillons de période à période, des moyens de détermination d'erreur pour élaborer une information d'erreur entre l'échantillon prédit et l'échantillon présent dès que p + 1 échantillons ont été obtenus depuis le début d'une période de modulation et des moyens d'ajustages pour corriger, par une méthode itérative, des coefficients initiaux afin de minimiser l'information d'erreur, ces coefficients initiaux étant choisis dans un premier ensemble de coefficients initiaux fixes ou dans un deuxième ensemble constitué par la valeur des coefficients établis lors d'une période de modulation précédente, des moyens de calculs de densité spectrale pour établir les raies du spectre des échantillons de l'onde de battement à partir des coefficients "$a_i$" et des moyens de détermination de l'information de distance à fournir à l'indicateur, élaborée à partir desdites raies.

2.  Dispositif pour mesure la distance "h" qui le sépare d'un objet selon la revendication 1, caractérisé en ce que ledit premier ensemble de coefficients est formé d'une pluralité de coefficients de valeur nulle et d'un seul coefficient "$a_o$" considéré comme valeur unitaire.

3.  Dispositif pour mesurer la distance "h" qui le sépare d'un objet selon l'une des revendications 1 ou 2, caractérisé en ce que les moyens de calculs sont prévus pour élaborer une quantité :

$$\left|A(f)\right|^2 = v_p^2 + 2\cos(2\pi f).\,v_p - v_{p-1}$$

où f est la fréquence d'une raie à étudier et avec

$$v_i = a_i + 2\cos(2\pi f).v_{i-1} - v_{i-2}$$
$$v_{-1} = v_{-2} = 0$$

et une quantité définissant le spectre de fréquence telle que :

$$\left|X(f)\right|^2 = \frac{1}{\left|A(f)\right|^2}$$

**Claims**

1.  Device for measuring the distance "h" which separates it from an object, the device including a transmit circuit (5-10) for transmitting a wave exhibiting periods of linear frequency modulation towards the object, a receive circuit (20) for receiving the wave reflected by the object, a mixer circuit (22) for forming a beat wave from the transmitted wave and the received wave and a processing unit (35) operating on samples of the beat wave so as to deliver to an indicator (40) the distance datum "h", characterized in that the processing unit includes order p prediction means with adjustable coefficients "$a_i$" for predicting the value of a present sample from "p" earlier samples obtained over a same modulation period and which comprise means for storing the "p" first samples obtained over a modulation period while maintaining the coherence of phase of the samples from period to period, error determination means for calculating a datum for the error between the predicted sample and the present sample once p + 1 samples have been obtained from the start of a modulation period, and adjusting means for correcting, by an iterative method, initial coefficients so as to minimize the error datum, these initial coefficients being chosen from a first set of fixed initial coefficients or from a second set consisting of the value of the coefficients established during a previous modulation period, means for computing spectral density in order to establish the lines of the spectrum of the samples of the beat wave from the coefficients "$a_i$" and means for determining the distance datum to be delivered to the indicator and calculated from the said lines.

2.  Device for measuring the distance "h" which separates it from an object according to Claim 1, characterized in that the said first set of coefficients is formed by a plurality of coefficients of zero value and by a single coefficient "$a_0$" regarded as unit value.

3. Device for measuring the distance "h" which separates it from an object according to one of Claims 1 or 2, charcacterized in that the computing means are provided in order to calculate a quantity:

$$\left|A(f)\right|^2 = v_p^2 + 2\cos(2\pi f).v_p - v_{p}{-}_1$$

where f is the frequency of a line to be studied and with

$v_i = a_i + 2\cos(2\pi f).v_{i-1} - v_{i-2}$
$v_{-1} = v_{-2} = 0$

and a quantity defining the frequency spectrum and such that:

$$\left|X(f)^2 = \frac{1}{\left|A(f)\right|^2}\right.$$

**Patentansprüche**

1. Vorrichtung zum Messen der Entfernung "h" zu einem Objekt, wobei die Vorrichtung eine Sendeschaltung (5 bis 10) enthält, um in Richtung des Objekts eine Welle mit Perioden linearer Frequenzmodulation auszusenden, sowie eine Empfangsschaltung (20), um die vom Objekt reflektierte Welle zu empfangen, eine Mischschaltung (22), um eine Schwebungswelle aus der ausgesendeten Welle und der empfangenen Welle zu bilden, sowie ein Verarbeitungsorgan (35), das auf Abtastwerte der Schwebungswelle einwirkt, um einer Anzeigevorrichtung (40) die Information über die Entfernung "h" bereitzustellen, dadurch gekennzeichnet, daß das Verarbeitungsorgan Mittel zur Voraussage der Ordnung "p" von einstellbaren Koeffizienten "$a_i$" enthält, um die Größe eines gegenwärtigen Abtastwertes ausgehend von "p" vorherigen, während einer gleichen Modulationsperiode erhaltenen Abtastwerten vorauszusagen, die wiederum Mittel zum Speichern von "p" ersten Abtastwerten aufweisen, die während einer Modulationsperiode erhalten wurden, indem die Phasenkohärenz der Abtastwerte von Periode zu Periode aufrechterhalten wird, sowie Mittel zur Bestimmung eines Fehlers, um eine Information über den Fehler zwischen dem vorausgesagten Abtastwert und dem gegenwärtigen Abtastwert auszuarbeiten, sobald p + 1 Abtastwerte seit dem Beginn einer Modulationsperiode erhalten sind, und Einstellmittel, um mittels einer iterativen Methode anfängliche Koeffizienten zu korrigieren, damit die Fehlerinformation minimiert wird, wobei diese anfänglichen Koeffizienten aus einer ersten Gruppe von festen Anfangskoeffizienten oder aus einer zweiten Gruppe gewählt sind, die aus dem Wert der bei einer vorhergehenden Modulationsperiode aufgestellten Koeffizienten gebildet sind, Mittel zum Berechnen der Spektraldichte, um Spektrallinien der Abtastwerte der Schwebungswelle ausgehend von den Koeffizienten "$a_i$" zu erhalten, und Mittel zur Bestimmung der zur Anzeigevorrichtung zu übertragenden Information über die Entfernung, die ausgehend von den Linien bestimmt wurde.

2. Vorrichtung zum Messen der Entfernung "h" zu einem Objekt nach Anspruch 1, dadurch gekennzeichnet, daß die erste Koeffizientengruppe aus mehreren Koeffizienten mit dem Wert Null sowie einem einzigen Koeffizienten "$a_0$" gebildet ist, der als Einheitswert betrachtet wird.

3. Vorrichtung zum Messen der Entfernung "h" zu einem Objekt nach einem der Ansprüche 1 oder 2, dadurch gekennzeichnet, daß die Berechnungsmittel dafür vorgesehen sind, eine Menge

$|A(f)|^2 = v_p^2 + 2\cos(2\pi f).v_p - v_{p-1}$

zu bestimmen, in der f die Frequenz einer zu untersuchenden Linie ist, wobei gilt:

$v_i = a_i + 2\cos(2\pi f).v_{i-1} - v_{i-2}$

$$v_{-1} = v_{-2} = 0,$$

sowie eine das Frequenzspektrum definierende Menge

$$|X(f)|^2 = 1/|A(f)|^2.$$

FIG.1

FIG.2

FIG. 3

FIG. 6

FIG. 4

FIG. 5